(19) Europäisches Patentamt
European Patent Office
Office européen des brevets

(11) EP 0 395 992 B1

(12) EUROPÄISCHE PATENTSCHRIFT

(45) Veröffentlichungstag und Bekanntmachung des Hinweises auf die Patenterteilung:
**13.03.1996 Patentblatt 1996/11**

(51) Int Cl.[6]: **G03F 7/039**, H01L 21/312, H01L 21/47, C08G 64/00, C08G 75/00, C08G 77/00

(21) Anmeldenummer: **90107724.8**

(22) Anmeldetag: **24.04.1990**

# (54) Strahlungsempfindliche Polymere und positiv arbeitendes Aufzeichnungsmaterial

Radiosensitive polymer and positive working recording material

Polymère radiosensible et matériau d'enregistrement à procédé positif

(84) Benannte Vertragsstaaten:
**BE CH DE FR GB IT LI NL**

(30) Priorität: **29.04.1989 DE 3914407**

(43) Veröffentlichungstag der Anmeldung:
**07.11.1990 Patentblatt 1990/45**

(73) Patentinhaber: **BASF Aktiengesellschaft**
**D-67063 Ludwigshafen (DE)**

(72) Erfinder: **Schwalm, Reinhold, Dr.**
**D-6706 Wachenheim (DE)**

(56) Entgegenhaltungen:
**EP-A- 0 115 021** **EP-A- 0 123 159**
**DE-A- 2 345 493** **DE-A- 3 542 778**
**DE-A- 3 628 046** **DE-A- 3 841 413**
**DE-A- 3 841 422**

- **CHEMICAL ABSTRACTS, Band 107, Nr. 22, 30. November 1987, Columbus, Ohio, USA, ISHIKAWA MATSUO et al.: "Dissilane-containing polymers"**
- **CHEMICAL ABSTRACTS, Band 110, Nr. 2, 9. Jänner 1989, Columbus, Ohio, USA, HOSAKA YUKIHIRO et al.: "Preparation of 1,2-quinone diazide compounds for positive-working photoresists"**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

EP 0 395 992 B1

## Beschreibung

Die Erfindung betrifft strahlungsempfindliche Polymere, die säurelabile Gruppen und Oniumsalze in der Polymerhauptkette enthalten, die durch Einwirkung von Licht und anschließende thermische Behandlung zu niedermolekularen Produkten abgebaut werden, die im Vakuum oder durch Behandlung mit alkalischen oder polaren Lösungsmitteln entfernt werden können, so daß sie sich für Photoresists eignen.

Strahlungsempfindliche, positiv arbeitende Polymere sind bekannt. So werden besonders Poly(alkyl-methacrylate) als Photoresists eingesetzt, da sie unter der Einwirkung von Licht einen Abbau des Molekulargewichts erleiden und dadurch eine höhere Löslichkeit als die hochmolekularen, nicht belichteten Bereiche aufweisen.

Als weitere Klasse sind Poly-(olefinsulfone) zu nennen, die bei Bestrahlung ebenfalls abbauen und Schwefeldioxid freisetzen.

Auch eine Reihe von polymergebundenen Sulfoniumsalzen, wie z.B.

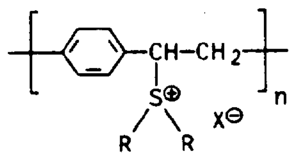

(vgl. Polymer, 27, 1709 (1986))

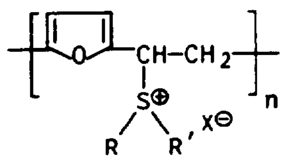

(vgl. EP-A- 246 931)

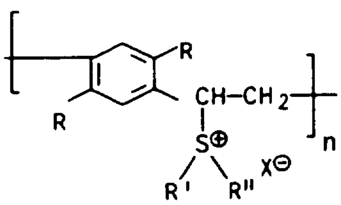

(vgl. EP-A- 246 931 und Polym. Commun. 26, 362 (1985)) worin

| | |
|---|---|
| R, R′, R″ = | Alkyl |
| X = | Halogen |
| n > | 5 sind, |

sind bereits beschrieben worden.

Weiterhin sind strahlungsempfindliche Polymere bekannt, welche Sulfoniumsalzeinheiten in der Polymerseitenkette enthalten (vgl. H. Tagoshi und T. Endo, J. Polym. Sci., Part C: Polym. Lett., Vol. 26, 77-81 (1988); jedoch enthalten diese Polymeren keine säurelabilen Gruppen, sondern Spiroorthoester, die unter der Einwirkung von Licht vernetzen.

Ebenfalls sind photosensitive Polymere bekannt, die Aryl-Onium-Salze, wie Iodonium- oder Sulfoniumsalze, in der Polymerhauptkette enthalten (vgl. J.V. Crivello, and J.H.W. Lam, J. Polym. Sci., Chem. Ed., 17, 3845-3858 (1979) und J.V. Crivello, J. L. Lee and D.A. Conlon, Makromol. Chem., Macromol. Symp. 13/14, 145-160 (1988)). Diese Oniumsalze sind in Polyimidketten eingebaut und spalten bei Belichtung an der Oniumeinheit, so daß eine Reduktion des Molekulargewichts erreicht wird. Da die Quantenausbeute der Oniumsalze <1 ist, ist die erreichbare Empfindlichkeit relativ gering.

Aufgabe der vorliegenden Erfindung ist es, Photoresistmaterialien zur Verfügung zu stellen, die eine homogene Verteilung der photoaktiven Gruppen in der Resistschicht gewährleisten, hohe Empfindlichkeit zeigen und gegebenenfalls trocken, d.h. ohne Anwendung von Lösungsmitteln entwickelbar sind.

Diese Aufgabe läßt sich überraschenderweise durch die erfindungsgemäßen strahlungsempfindlichen Polymeren lösen, die in der Polymerhauptkette sowohl säurelabile, insbesondere Carbonatgruppierungen als auch Sulfoniumsalzgruppen, mit nichtnucleophilen Gegenionen enthalten.

Gegenstand der vorliegenden Erfindung sind strahlungsempfindliche Polymere, die dadurch gekennzeichnet sind, daß sie in der Polymerhauptkette sowohl säurelabile Gruppen, als auch Sulfoniumsalzgruppierungen mit nichtnucleophilen Gegenionen enthalten.

Die erfindungsgemäßen Strahlungsempfindlichen Polymeren enthalten vorzugsweise Einheiten der allgemeinen Formel (I) und (III) oder (II) und (III)

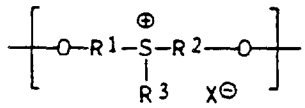 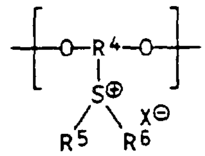 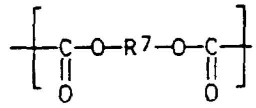

(I) (II) (III)

enthalten, worin

$R^1$ und $R^2$ untereinander gleich oder verschieden sind und Alkylen, beispielsweise mit 1 bis 9 Kohlenstoffatomen, wie $-CH_2-CH_2-$ oder $-CH_2-CH_2-CH_2-$ Phenylen, Naphthylen oder substituiertes Phenylen, wie z.B.

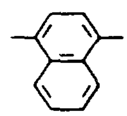 , 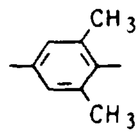 , 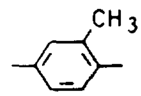 , 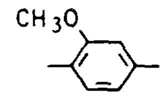

bedeuten,

$R^3$ Alkyl, beispielsweise mit 1 bis 9 Kohlenstoffatomen, wie z.B. Methyl, Ethyl, Cyclohexyl, Phenyl, Naphthyl oder subst. Phenyl, wie z.B. 4-tert.-Butylphenyl, 4-Methyl-phenyl oder 4-Methoxyphenyl,

$R^4$ dreibindiger aliphatischer oder aromatischer Kohlenwasserstoffrest, wie z.B.

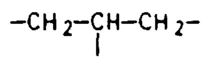 , 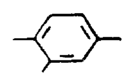 ,

$R^5$ und $R^6$ untereinander gleich oder verschieden sind und Alkyl oder Phenyl bedeuten oder $R^5$ und $R^6$ miteinander zu einem 5- oder 6-gliedrigen Ring geschlossen sind, wie z.B. Methyl, Phenyl, 4-Methylphenyl- oder $-CH_2-CH_2-CH_2-CH_2-$.

$R^7$ Alkylen, beispielsweise mit 2 bis 10 Kohlenstoffatomen, Phenylen oder 1,4-Phenylendialkylen, wie z.B.

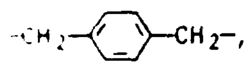

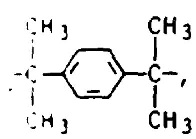

wobei zweiwertige Reste mit Verzweigungen, wie z.B.

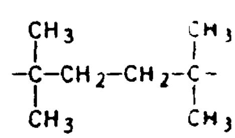 ,

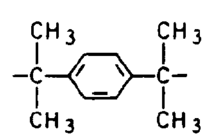 und 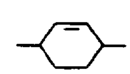

bevorzugt sind, oder zweiwertige, Silicium enthaltende Reste, wie z.B.

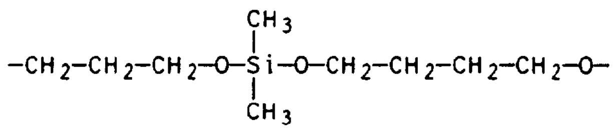

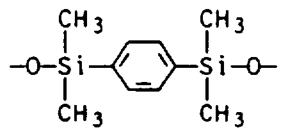

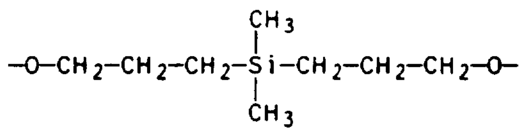

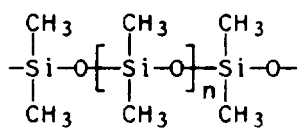

und

X Halogen, wie z.B. I, Br, $ClO_4$, $F\text{-}SO_3$, $CF_3\text{-}SO_3$, $BF_4$, $PF_6$, $AsF_6$ oder $SbF_6$

sein kann.

Die erfindungsgemäßen strahlungsempfindlichen Polymeren enthalten im allgemeinen zwischen 2 und 50, vorzugsweise zwischen 5 und 25 Mol.% Monomereinheiten mit Sulfoniumsalzgruppierungen einkondensiert.

Sie bestehen vorzugsweise aus kondensierten Einheiten,
mindestens einer der unter (I) angegebenend Einheiten mit
mindestens einer der unter (III) angegebenend Einheiten
oder
mindestens einer der unter (II) angegebenen Einheiten mit
mindestens einer der unter (III) angegebenen Einheiten

(I) (II) (III)

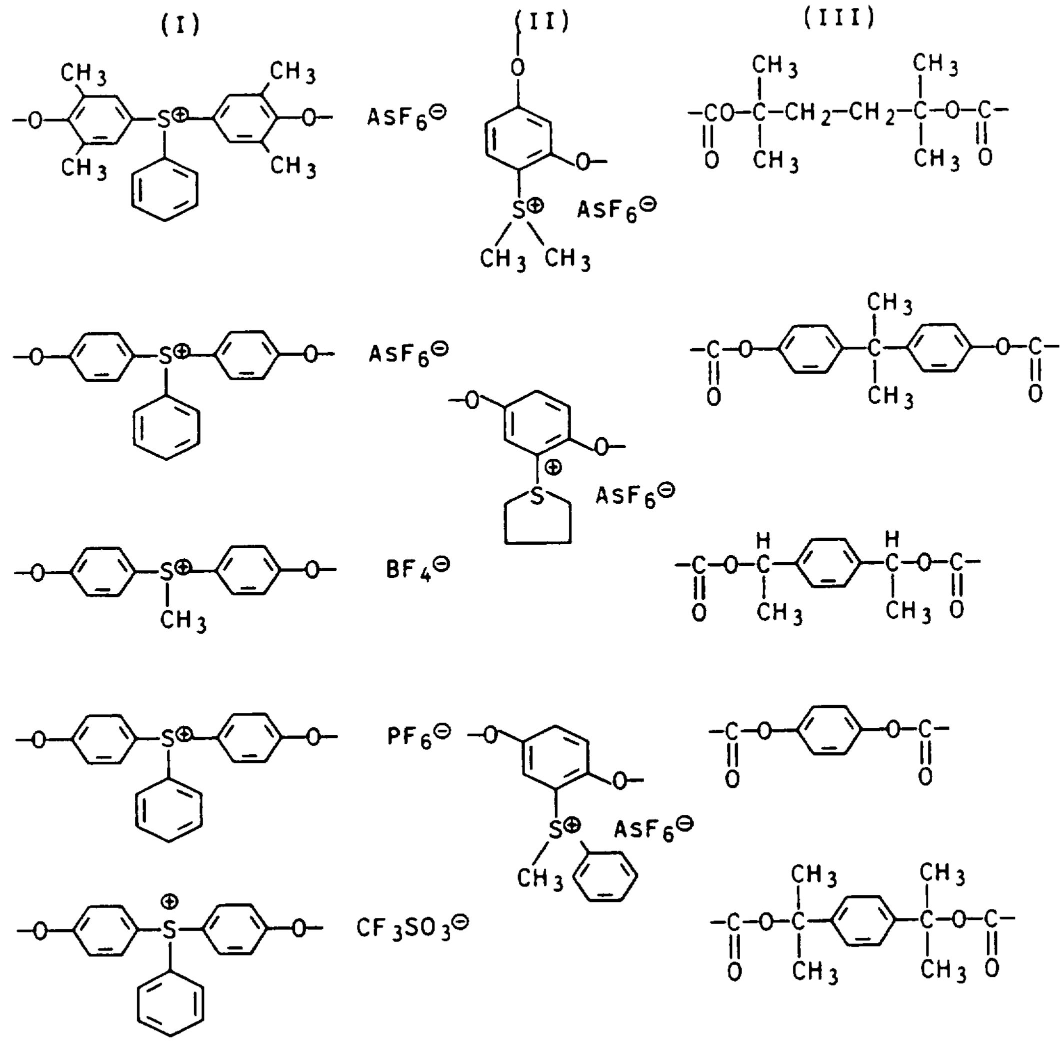

Gegenstand der vorliegenden Erfindung ist auch ein positiv arbeitendes Aufzeichnungsmaterial, bei dem die belichteten Bereiche mit einem alkalischen Entwickler oder polaren Lösungsmittel oder im Vakuum entfernt werden, wobei strahlungsempfindliche Polymere gemäß einem der vorhergehenden Ansprüche eingesetzt werden.

Gegenstand der vorliegenden Erfindung ist außerdem ein Verfahren zur Herstellung von Halbleiterbauelementen, wobei ein erfindungsgemäßes strahlungsempfindliches Polymer auf ein, ein Halbleitermaterial enthaltendes Substrat aufgebracht, die strahlungsempfindliche Schicht in einem gewünschten Muster mit elektromagnetischer Strahlung bestrahlt, gegebenenfalls auf Temperaturen von 60°C bis 120°C aufgeheizt, das Muster entwickelt und die Herstellung des Halbleiterbauelementes in üblicher Weise zu Ende geführt wird.

Zu den Aufbaukomponten des erfindungsgemäßen Polymeren ist folgendes auszuführen:

1. Sulfoniumsalze

Werden die erfindungsgemäßen Polymeren durch Polykondensationsreaktionen aufgebaut, so können die Sulfoniumsalzeinheiten der allgemeinen Formel (I) über die Hydroxylgruppen in das Polykondensat eingebaut werden. Beispiele für solche Sulfoniumsalze sind:

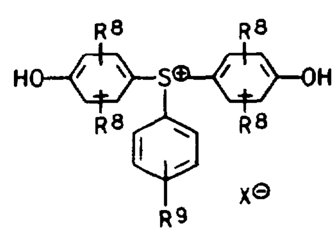

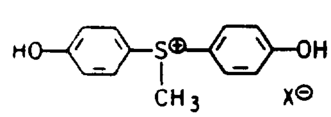

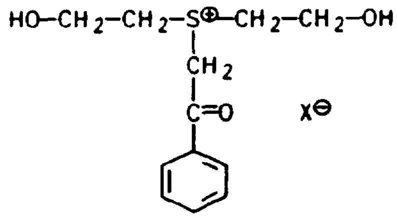
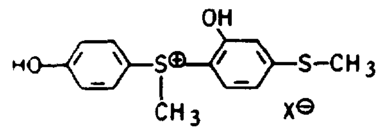

$R^8$ = H, Alkyl, Halogen, Alkoxy ($C_1$-$C_6$)
$R^9$ = H, Alkyl, Halogen, Alkoxy ($C_1$-$C_6$).

Obwohl diese Sulfoniumsalze bevorzugt sind, können auch solche Monomerbausteine verwendet werden, bei denen die einkondensierbaren Gruppen an einem Phenylrest lokalisiert sind. Beispiele derartiger geeigneter Sulfoniumsalze sind:

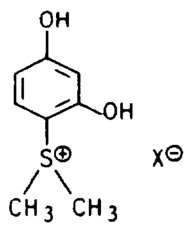
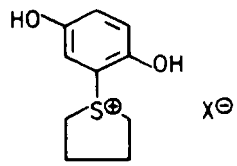
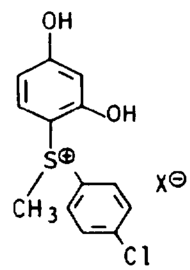
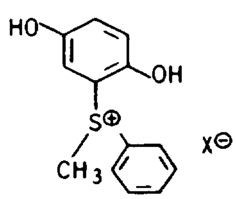
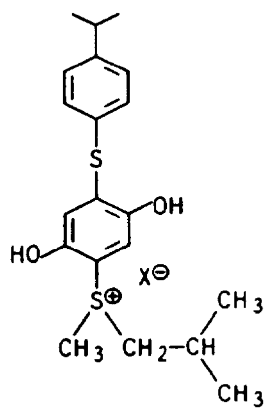
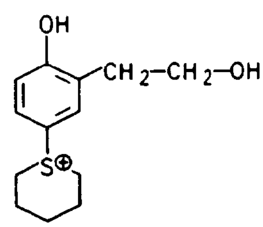

$X^{\ominus}$ = $Br^{\ominus}$, $Cl^{\ominus}$, $ClO_4^{\ominus}$, $FSO_3^{\ominus}$, $CF_3SO_3^{\ominus}$, $BF_4^{\ominus}$, $PF_6^{\ominus}$, $AsF_6^{\ominus}$, $SbF_6^{\ominus}$

2. Cokondensationskomponenten

Im Sinne der Erfindung werden in das Copolymerisat solche Gruppierungen eingebaut, welche durch Säure leicht spaltbar sind. Beispiele solcher Gruppierungen sind Ether, Acetale, Orthoester, Carbonate und andere.

Bevorzugt werden als säurelabile Gruppe Carbonatgruppierungen erzeugt, so daß als Cokondensationskomponenten aliphatische oder aromatische Diole in Frage kommen. Beispiele für derartige Diole sind:

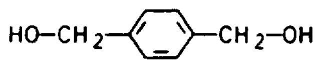

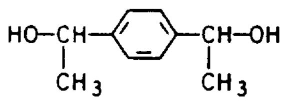

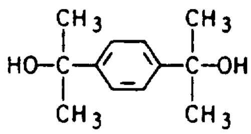

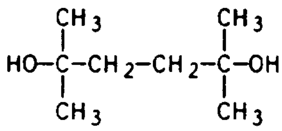

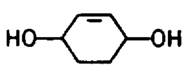

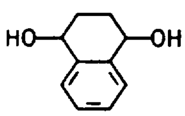

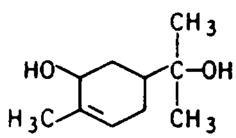

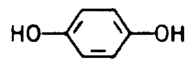

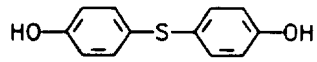

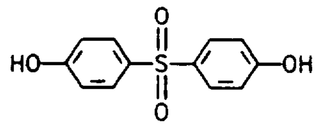

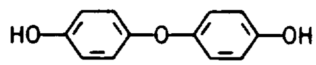

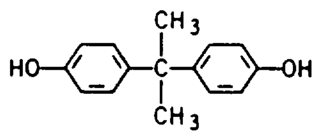

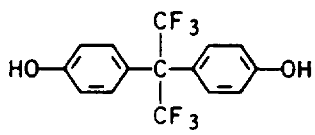

Die Polykondensationsreaktionen können nach bekannten Methoden durchgeführt werden, indem mit Hilfe von Kohlensäurederivaten, wie Phosgen, Carbonyl-bis-imidazol oder anderen geeigneten Derivaten kondensiert wird. In speziellen Fällen erweist es sich als günstig, die Diolkomponenten mit Kohlensäurederivaten vor der eigentlichen Kondensationsreaktion zu aktiven Esterverbindungen folgender Struktur umzusetzen:

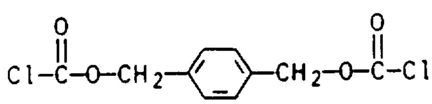

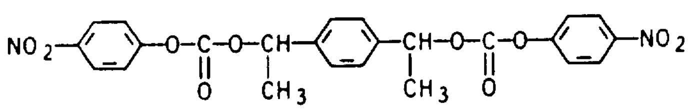

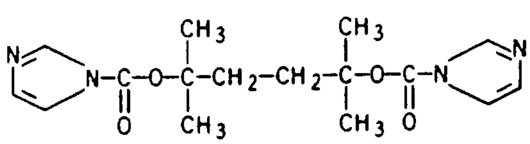

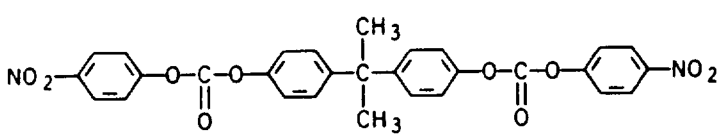

Weiterhin kommen auch eine Reihe von hydroxylterminierten Siloxanen folgender Strukturformeln in Betracht:

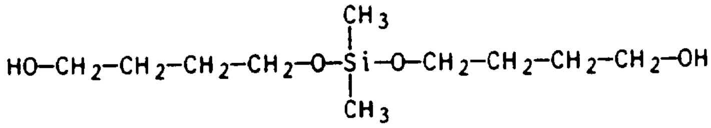

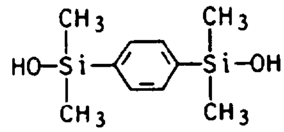

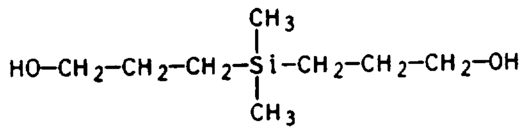

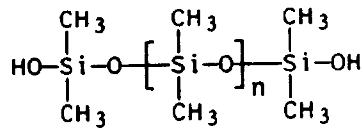

n = 1-100

Die Polykondensationsreaktionen lassen sich nach bekannten Methoden zur Synthese von Polycarbonaten mit Phosgen (vgl. D. Braun, H. Cherdron und W. Kern, Praktikum der makromolekularen organischen Chemie, S. 257), Carbonyl-bis-imidazol (vgl. H. Staab, Angew. Chem., 74, 407, (1962) bzw. aktiven Estern, wie 4-Nitrophenyl-carbonaten (vgl. J. Frechet, Makromol. Chem., Rapid Comm. 7, 121-126 (1986), durchführen. Dabei werden die hydroxyfunktionellen Sulfoniumsalze in entsprechenden Mengen mit den entsprechenden Diolen bzw. den aktiven Esterderivaten in einem geeigneten Lösungsmittel kondensiert.

Eine weitere Möglichkeit der Synthese der erfindungsgemäßen strahlungsempfindlichen Polymeren ist die Herstellung eines Polykondensats, welches Schwefelatome in der Hauptkette enthält und anschließend mit einem Iodoniumsalz gemäß folgender Gleichung umgesetzt wird:

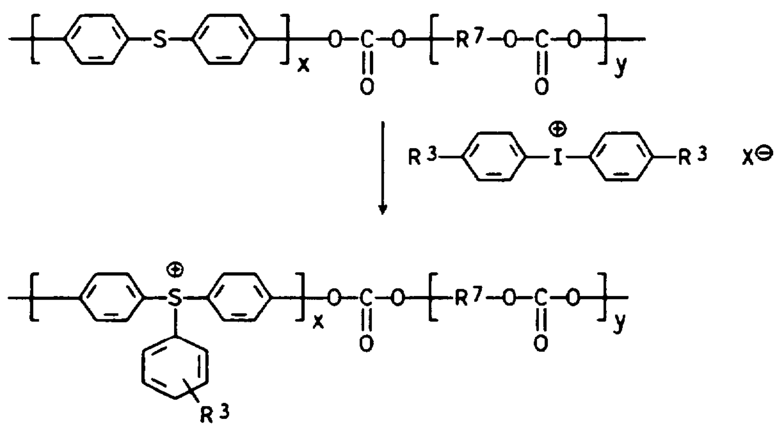

x = 0.02-0.5
y = 0.5-0.98

Zur Synthese von Sulfoniumsalzen über Iodoniumsalze vgl. J. Crivello, Advances in Polymer Science 62, Springer Verlag Heidelberg 1984, S. 9 und darin angegebene Literatur.

Die Molekulargewichte der erfindungsgemäßen Polymeren liegen im allgemeinen zwischen 5.000 und 200.000, vorzugsweise zwischen 10.000 und 80.000 (Molekulargewicht ermittelt nach Lichtstreuung).

Für die Weiterverarbeitung und Verwendung werden die erfindungsgemäßen Polymeren im allgemeinen in einem geeigneten Lösungsmittel, z.B. Cyclohexanon, Ethylenglykol-ethylether-acetat oder Methylpropylenglykolacetat gelöst, als dünner Film von ca. 1 bis 2 µm auf ein Substrat, beispielsweise einen Siliziumwafer aufgebracht, unter kontrollierten Bedingungen z.B. zwischen 60°C und 120°C ausgeheizt, bildmäßig belichtet und nochmals unter kontrollierten Bedingungen, zwischen 40°C und 120°C ausgeheizt. Danach können die belichteten Bereiche mit einem alkalischen oder polaren Lösungsmittel entfernt werden. Gegebenenfalls können die in die Monomerbausteine zerfallenen belichteten Bereiche auch im Vakuum entfernt und, gegebenenfalls mit Hilfe eines kurzen Nachspülvorganges mit einem polaren

Lösungsmittel, somit sauber ausgebildete Strukturen erzeugt werden.

Geeignete Entwickler sind alkalische Lösungen im pH-Wertbereich oberhalb 11, z.B. wäßrige Lösungen von Alkalihydroxiden, Tetraalkylammoniumhydroxiden oder Aminen, oder polare Lösungsmittel wie beispielsweise Isopropanol.

Die erfindungsgemäßen Polymeren eignen sich für die Belichtung im kurzwelligen UV-Bereich unterhalb 300 nm, mit Röntgen- und Elektronenstrahlen sowie bei geeigneter Wahl der Monomerbausteine, d.h., solche die im längerwelligen UV-Bereich absorbieren, oder bei Zusatz von Sensibilisatoren, wie Phenothiazin oder Perylen, auch für die Belichtung im nahen UV-Breich oberhalb 300 nm.

Die erfindungsgemäßen strahlungsempfindlichen Polymeren eignen sich zur Herstellung von Photoresists, insbesondere zur Herstellung von Resists für die Mikrolithographie sowie als Leiterplattenresiste. Sie zeichnen sich insbesondere durch hohe Empfindlichkeit, hohe Auflösung, gute Ätzstabilität, hohe Beständigkeit gegen Plasmen, insbesondere Sauerstoffplasmen bei Verwendung von Siloxanen in der Polymerkette sowie gegebenenfalls Trockenentwickelbarkeit aus.

Die Herstellung von Halbleiterbauelementen unter Verwendung der erfindungsgemäßen strahlungsempfindlichen Polymeren erfolgt in üblicher Weise mit Hilfe der Photolithographietechnik, wie sie beispielsweise in "Peter Kästner, Halbleitertechnologie", Vogel-Verlag, Würzburg 1980, Seiten 75 bis 117 beschrieben ist.

Die in den Beispielen genannten Teile und Prozente sind, soweit nicht anders angegeben, Gewichtsteile bzw. Gewichtsprozente.

Beispiel 1

Synthese der Polymeren über Iodoniumsalze

Es wird ein Polycarbonat analog der Vorschrift in D. Braun, H. Cherdron und W. Kern, Praktikum der makromolekularen organischen Chemie, Hüthig-Verlag, S. 257, dargestellt, indem anstatt Bisphenol A die analoge Schwefelverbindung Bis-(hydroxyphenyl)-sulfid eingesetzt wird.

2,44 Teile dieses Polycarbonats (Poly-oxycarbonyloxy-1,4-phenylenthio-1,4-phenylen), 4,7 Teile Diphenyliodonium-hexafluoroarsenat und 0,2 Teile Kupfer(II)acetat werden in einem Kolben zusammengegeben und 3 Stunden bei 120°C gerührt. Das Reaktionsgemisch wird in ein Becherglas gegeben und dreimal miit Ether extrahiert. Es sind 3,0 Teile eines strahlungsempfindlichen Polymeren entstanden, welches Carbonat (IR: 1730 $cm^{-1}$) und Sulfoniumhexafluoroarsenat-gruppierungen (IR: 700 $cm^{-1}$) enthält.
Elementaranalyse: C: 48,8 H: 3,9 S: 6,4 As: 12,1 F: 18,7 J: < 0,5

Untersuchung der Lithographie:

2,0 Teile dieses Polymeren werden in 8,0 Teilen Cyclohexanon gelöst, durch ein Teflonfilter mit der Porenweite 0,2 µm filtriert und in einer Schichtdicke von ca. 1,0 µm auf Siliziumwafer aufgeschleudert, die vorher mit Hexamethyldisilazan als Haftvermittler behandelt wurden. Die beschichteten Wafer wurden 5 Minuten bei 90°C auf einer Heizplatte ausgeheizt. Die Wafer wurden dann in einem "Süss MA56 Kontakt/Proximity-Belichter" im Kontaktverfahren mit Excimer-Laserlicht der Wellenlänge 248 nm durch eine chrombeschichtete Quarzmaske bildmäßig belichtet. Optimale Belichtungszeiten liegen zwischen 5 und 10 Sekunden. Nach der Belichtung werden die Wafer 1 Minute bei 90°C auf einer Heizplatte ausgeheizt und anschließend entwickelt, indem sie 1 Minute in eine wäßrig alkalische Lösung, z.B. Microposit® MF 319 (Shipley), getaucht werden. Es werden sauber entwickelte Strukturen mit einer Auflösung von 1 µm erhalten.

Beispiel 2

Es wird wie in Beispiel 1 verfahren, jedoch wird anstatt des Polycarbonates aus reinem Bis-(hydroxyphenyl)sulfid ein Polycarbonat aus einer 1:1 Mischung Bisphenol A und Bis-(hydroxyphenyl)-sulfid eingesetzt. Die Belichtungszeiten liegen zwischen 10 und 20 Sekunden, ansonsten wird wie in Beispiel 1 verfahren und man erhält ebenfalls sauber ausentwickelte 1 µm Strukturen.

Beispiel 3

Es wird wie in Beispiel 1 verfahren, jedoch wird das Polycarbonat aus Beispiel 2 mit Diphenyliodonium-hexafluorophosphat anstatt dem Arsenat umgesetzt. Die Lichtempfindlichkeit dieses Polymeren ist wesentlich geringer, es werden Belichtungszeiten von ca. 50 Sekunden benötigt.

Beispiel 4

Als Ausgangsverbindungen für die Polykondensationsreaktion werden Phenyl-bis-(4-hydroxiphenyl-)sulfoniumhexafluoroarsenat gemäß Beispiel 2 in DE-OS-37 21 740 und Bis-(4-nitrophenyl)-1,1,4,4-tetramethyltetramethylen-dicarbonat gemäß Vorschrift in Makromol. Chem., Rapid Comm. 7, 123 (1986) synthetisiert.

Ein strahlungsempfindliches Polymer wird durch Kondensation von 4,84 Teilen Phenyl-bis-(hydroxyphenyl)sulfoniumhexafluoroarsenat mit 4,76 Teilen Bis-(4-nitrophenyl)-1,1,4,4-tetramethyltetramethylendicarbonat in Gegenwart von 12 Teilen trockenem Kaliumcarbonat, 1,2 Teilen Kronenether 18-crown-6 und 40 Teilen Dichlormethan durch Erhitzen am Rückfluß während einer Reaktionszeit von 72 Stunden erhalten. Die Ausbeute an rein weißem Polymer beträgt: 2,8 Teile. Die spektroskopische Analyse stimmt mit der erwarteten Struktur überein.

Molekulargewicht (LS): 57.500 g/mol

Die lithographischen Untersuchungen werden wie in Beispiel 1 durchgeführt. Es resultieren Belichtungszeiten zwischen 0,5 und 1,5 Sekunden bei ebenfalls sauber ausentwickelten 1 µm Stukturen.

Beispiel 5

Es wird wie in Beispiel 4 verfahren, jedoch wird anstatt Bis-(4-nitrophenyl)-1,1,4,4-tetramethyltetramethylen-dicarbonat Bis-(4-nitrophenyl)-1,4-phenylendiethyliden-dicarbonat verwendet. Ausbeute: 46 %. Testergebnis: Die Untersuchungen werden wie in Beispiel 1 durchgeführt. Bei einer Belichtungszeit von 25 Sekunden werden ausentwickelte Strukturen enthalten.

Beispiel 6

Es wird wie in Beispiel 5 verfahren, jedoch wird anstatt Phenyl-bis-(hydroxyphenyl)sulfoniumhexafluoroarsenat Phenyl-methyl-2,5-dihydroxyphenyl-sulfoniumhexafluorophosphat verwendet. Ausbeute: 23 %. Testergebnis: Die lithographischen Untersuchungen werden wie in Beispiel 1 durchgeführt und es resultieren ebenfalls sauber entwickelte Strukturen, wenn man 10 Sekunden belichtet.

## Patentansprüche

1. Strahlungsempfindliche Polymere, dadurch gekennzeichnet, daß sie in der Polymerhauptkette sowohl säurelabile Gruppen, als auch Sulfoniumsalzgruppen mit nichtnucleophilen Gegenionen enthalten.

2. Strahlungsempfindliche Polymere nach Anspruch 1, dadurch gekennzeichnet, daß sie Einheiten der allgemeinen Formel (I) und (III) oder (II) und (III)

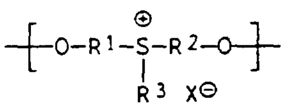

(I)

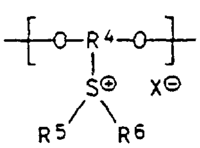

(II)

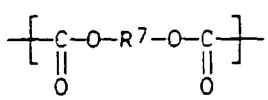

(III)

enthalten, worin

| | |
|---|---|
| $R^1$ und $R^2$ | untereinander gleich oder verschieden sind und Alkylen, Phenylen, substituiertes Phenylen oder Naphthylen bedeuten, |
| $R^3$ = | Alkyl, Phenyl, substituiertes Phenyl oder Naphthyl-, |
| $R^4$ = | dreibindiger aliphatischer oder aromatischer Kohlenwasserstoffrest, |
| $R^5$ und $R^6$ | untereinander gleich oder verschieden sind und Alkyl oder Phenyl bedeuten oder R5 und R6 miteinander zu einem 5- oder 6-gliedrigen Ring geschlossen sind, |
| $R^7$ = | Alkylen, Phenylen, 1,4-Phenylen-dialkylen, oder zweiwertige Si-enthaltende Reste |

und

X = Halogen, $ClO_4$, $F\text{-}SO_3$, $CF_3\text{-}SO_3$, $BF_4$, $PF_6$, $AsF_6$ oder $SbF_6$

sein kann.

**3.** Strahlungsempfindliche Polymere nach einem der Ansprüche 1 oder 2, dadurch gekennzeichnet, daß sie als säurelabile Gruppen Carbonatgruppen enthalten.

**4.** Strahlungsempfindliche Polymere nach einem der Ansprüche 1 bis3 , dadurch gekennzeichnet, daß sie zwischen 2 und 50 mol% Monomereinheiten mit Sulfoniumsalzgruppierungen einkondensiert enthalten.

**5.** Strahlungsempfindliche Polymere nach einem der Ansprüche 2 bis 4, dadurch gekennzeichnet, daß sie aus kondensierten Einheiten mindestens einer der unter (I) angegebenen Einheiten mit mindestens einer der unter (III) angegebenen Einheiten oder mindestens einer der unter (II) angegebenen Einheiten mit mindestens einer der unter (III) angegebenen Einheiten

(I)

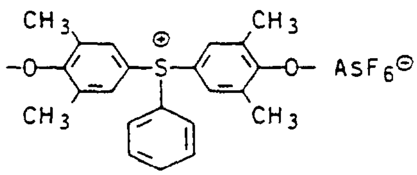

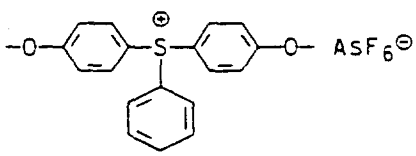

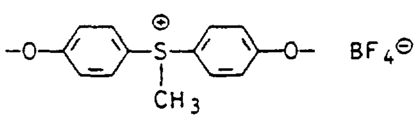

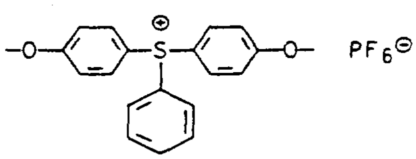

(II)

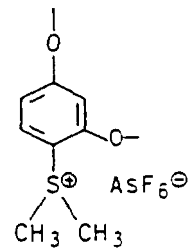

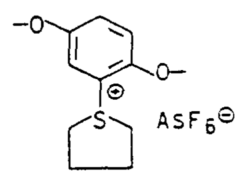

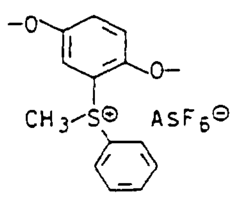

(III)

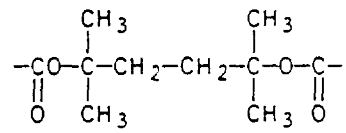

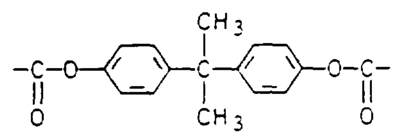

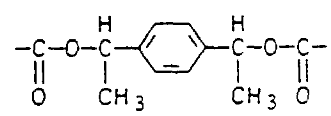

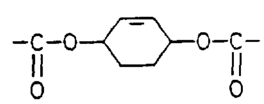

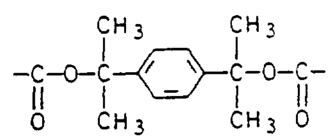

bestehen.

**6.** Positiv arbeitendes Aufzeichnungsmaterial, bei dem die belichteten Bereiche mit einem alkalischen Entwickler oder polaren Lösungsmittel oder im Vakuum entfernt werden, dadurch gekennzeichnet, daß strahlungsempfindliche Polymere gemäß einem der vorhergehenden Ansprüche eingesetzt werden.

**7.** Verfahren zur Herstellung von Halbleiterbauelementen, dadurch gekennzeichnet, daß man ein strahlungsempfindliches Polymer gemäß einem der Ansprüche 1 bis 6 auf ein ein Halbleitermaterial enthaltendes Substrat aufbringt, die strahlungsempfindliche Schicht in einem gewünschten Muster mit elektromagnetischer Strahlung bestrahlt, gegebenenfalls auf Temperaturen von 60°C bis 120°C aufheizt, das Muster entwickelt und die Herstellung des Halbleiterbauelementes in üblicher Weise zu Ende führt.

## Claims

1. A radiation-sensitive polymer which contains, in the polymer main chain, both acid-labile groups and sulfonium salt groups with nonnucleophilic counterions.

2. A radiation-sensitive polymer as claimed in claim 1, which contains units of the formulae (I) and (III) or (II) and (III)

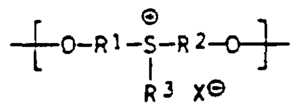

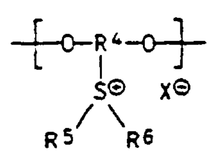

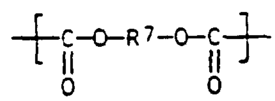

(I) (II) (III)

where

$R^1$ and $R^2$ are identical or different and are each alkylene, phenylene, substituted phenylene or naphthylene,
$R^3$ is alkyl, phenyl, substituted phenyl or naphthyl,
$R^4$ is a trivalent aliphatic or aromatic hydrocarbon radical,
$R^5$ and $R^6$ are identical or different and are each alkyl or phenyl or $R^5$ and $R^6$ together form a 5-membered or 6-membered ring,
$R^7$ is alkylene, phenylene, 1,4-phenylenedialkylene, or divalent Si-containing radicals
and
X is halogen, $ClO_4$, $F\text{-}SO_3$, $CF_3\text{-}SO_3$, $BF_4$, $PF_6$, $AsF_6$ or $SbF_6$.

3. A radiation-sensitive polymer as claimed in either of claims 1 or 2, which contains carbonate groups as the acid-labile groups.

4. A radiation-sensitive polymer as claimed in any of claims 1 to 3, which contains from 2 to 50 mol % of condensed monomer units having sulfonium salt groups.

5. A radiation-sensitive polymer as claimed in any of claims 2 to 4, which consists of condensed units of at least one of the units stated under (I) with at least one of the units stated under (III), or of at least one of the units stated under (II) with at least one of the units stated under (III)

(I)

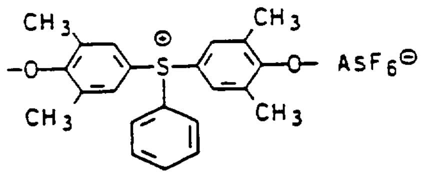

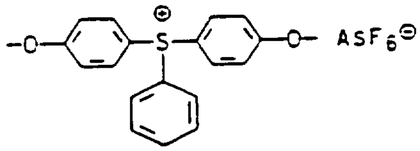

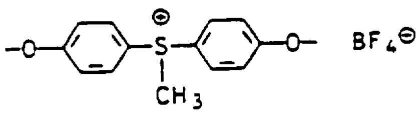

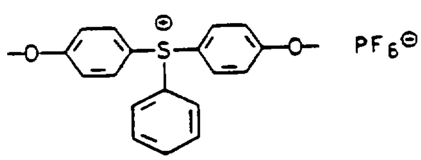

(II)

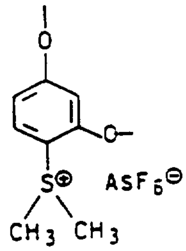

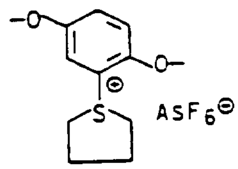

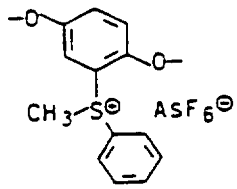

(III)

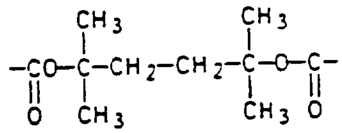

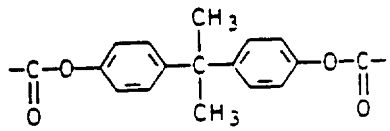

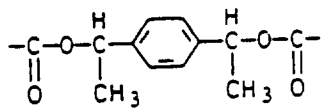

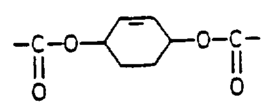

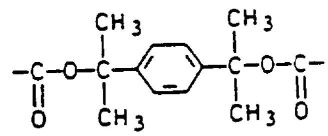

6. A positive-working recording material in which the exposed parts are removed using an alkaline developer or a polar solvent or under reduced pressure, wherein a radiation-sensitive polymer as claimed in one of the preceding claims is used.

7. A process for the production of semiconductor structural elements, wherein a radiation-sensitive polymer as claimed in any of claims 1 to 6 is applied to a substrate which contains a semiconductor material, the radiation-sensitive layer is exposed to electromagnetic radiation in a desired pattern and if necessary heated to 60-120°C, the pattern is developed and the production of the semiconductor structural element is completed in a conventional manner.

**Revendications**

1. Polymères photosensibles, caractérisés en ce qu'ils comportent dans la chaîne polymère principale aussi bien des groupes labiles aux acides que des groupes sel de sulfonium avec des ions complémentaires non nucléophiles.

2. Polymères photosensibles selon la revendication 1, caractérisés en ce qu'ils comportent des unités de formule générale (I) et (III) ou (II) et (III)

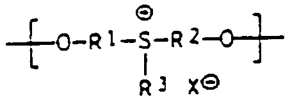

(I)

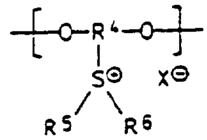

(II)

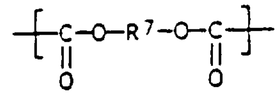

(III)

où

| | |
|---|---|
| $R^1$ et $R^2$ | sont identiques ou différents et désignent des groupes alkylène, phénylène, phénylène substitué ou naphtylène, |
| $R^3$ = | reste alkyle, phényle, phényle substitué ou naphtyle, |
| $R^4$ = | reste hydrocarboné trivalent aliphatique ou aromatique, |
| $R^5$ et $R^6$ | sont identiques ou différents et représentent un groupe alkyle ou phényle ou $R^5$ et $R^6$ sont cyclisés pour former entre eux un cycle à 5 ou 6 chaînons, |
| $R^7$ = | reste alkylène, phénylène, 1,4-phénylènedialkylène, ou des restes divalents contenant du Si, et |
| X | peut être un halogène, $ClO_4$, F-$SO_3$, $CF_3$-$SO_3$, $BF_4$, $PF_6$, $AsF_6$ ou $SbF_6$. |

**3.** Polymères photosensibles selon l'une des revendications 1 ou 2, caractérisés en ce qu'ils contiennent, comme groupes labiles aux acides, des groupes carbonate.

**4.** Polymères photosensibles selon l'une quelconque des revendications 1 à 3, caractérisés en ce qu'ils contiennent sous forme condensée entre 2 et 50% en mol d'unités monomères ayant des groupements sel de sulfonium.

**5.** Polymères photosensibles selon l'une quelconque des revendications 2 à 4, caractérisés en ce qu'ils consistent en des unités condensées d'au moins une des unités indiquées sous (I) avec au moins une des unités indiquées sous (III) ou en au moins une des unités indiquées sous (II) avec au moins une des unités indiquées sous (III)

(I)

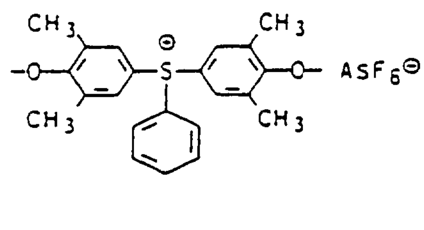

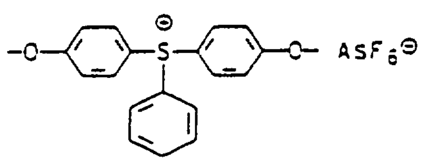

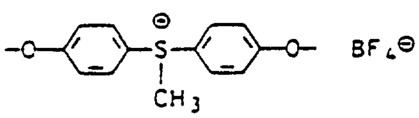

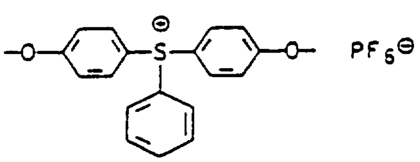

(II)

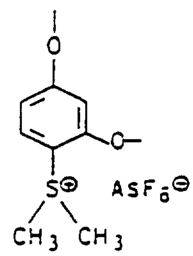

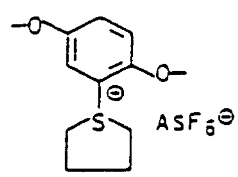

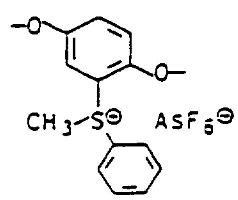

(III)

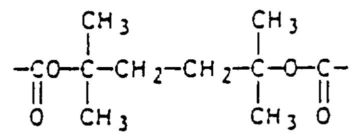

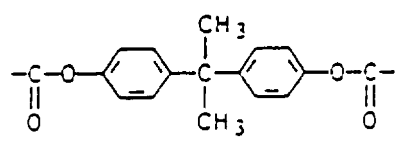

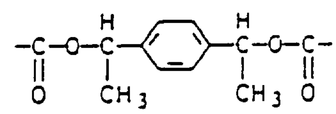

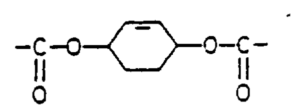

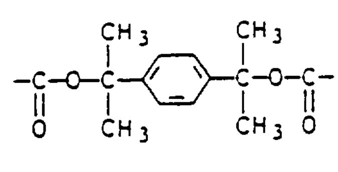

**6.** Matériau d'enregistrement à travail positif, dans lequel sont enlevées les régions illuminées, au moyen d'un révélateur alcalin ou d'un solvant polaire ou sous vide, caractérisé par le fait que sont incorporés des polymères photosensibles selon l'une des revendications précédentes.

**7.** Procédé de fabrication d'éléments semiconducteurs, caractérisé par le fait que l'on applique un polymère photosensible selon l'une des revendications 1 à 6 sur un substrat contenant un matériau semi-conducteur, on illumine la couche photosensible selon un motif souhaité par rayonnement électromagnétique, éventuellement on chauffe

à des températures de 60°C à 120°C, on révèle le motif et on poursuit de façon classique, jusqu'à achèvement, la fabrication de l'élément semi-conducteur.